# EUROPÄISCHE PATENTSCHRIFT

(11) **EP 1 898 294 B1**
(45) Veröffentlichungstag und Bekanntmachung des Hinweises auf die Patenterteilung: **19.10.2011**
(21) Anmeldenummer: 07112408.5
(22) Anmeldetag: 13.07.2007
(51) Int. Cl.: G06F 1/16, H05K 5/00, G01M 15/02

(54) **Handtestgerät**
Manual testing device
Appareil de test manuel

(30) Priorität: 08.09.2006 DE 102006042785
(43) Veröffentlichungstag der Anmeldung: 12.03.2008
(73) Patentinhaber: ROBERT BOSCH GMBH, 70442 Stuttgart (DE)
(72) Erfinder: Gustain, Romuald, 73207 Plochingen (DE); Loser, Ralf, 73235 Weilheim/Teck (DE)

(56) Entgegenhaltungen:
- DE-A1- 10 159 546
- US-B1- 6 181 992
- US-B1- 6 693 367

## Beschreibung

### Stand der Technik

Die Erfindung bezieht sich auf ein Handtestgerät mit einem bei der Benutzung in der Hand gehaltenen Gehäuse aus einem flachen unteren Gehäuseteil und einem flachen oberen Gehäuseteil, in dessen Oberseite eine Bedieneinheit mit Tastenanordnung und Sichtanzeigefeld aufgenommen ist.

Derartige Handtestgeräte, wie sie (ohne druckschriftlichen Beleg) als bekannt angenommen werden, dienen z.B. zum Überprüfen von Kraftfahrzeugfunktionen als Diagnosegeräte und besitzen ein robustes Gehäuse aus Oberteil und Unterteil sowie eine Bedieneinheit mit Tasten und Sichtanzeige, um Daten eingeben und angezeigte Messwerte bzw. Anweisungen an den Benutzer ablesen zu können. Hierbei verlangt die Montage der Bedieneinheit verschiedene Fertigungsschritte mit nicht geringem Aufwand.

Der Erfindung liegt die Aufgabe zugrunde, ein Handtestgerät der eingangs genannten Art bereit zu stellen, bei dem der Aufbau und die Fertigung vereinfacht und die Bedienung begünstigt werden.

### Offenbarung der Erfindung

### Vorteile der Erfindung

Diese Aufgabe wird mit den Merkmalen des Anspruches 1 gelöst. Hierbei ist vorgesehen, dass die Bedieneinheit eine einstückige, von dem oberen Gehäuseteil getrennt hergestellte Trägereinheit aufweist, die in einer vertieften Aufnahme des oberen Gehäuseteils eingesetzt und festgelegt ist und in der sowohl die Tastenanordnung als auch eine Sichtscheibe unter Abdichtung integriert sind.

Mit diesen Maßnahmen kann die Bedieneinheit einschließlich Tastenanordnung und Sichtscheibe präzise hergestellt und einfach montiert werden, so dass u.a. auch eine eindeutige, dichte Montage begünstigt wird und eine immer gleich bleibend gute Funktion sichergestellt ist.

Eine für die Montage und den Aufbau vorteilhafte Ausgestaltung besteht darin, dass die Trägereinheit als Trägermatte aus flexiblem und/oder elastischem Material hergestellt ist.

Für eine sichere Funktion und Abdichtung gegen Staub und Feuchtigkeit sind die Maßnahmen von Vorteil, dass die Tastenanordnung als mindestens eine Silikonschaltmatte mit Silikonflanken aufweisenden Tasten und Schnappscheiben aufweisenden Betätigungselementen ausgebildet ist.

Der Aufbau und die Montage werden dadurch begünstigt, dass die Tastenanordnung an in die Trägermatte eingebetteten elektrischen Verbindungsleitungen angeschlossen ist und über ein aus der Trägermatte herausgeführtes, durch eine Durchgangsöffnung in der Wandung des oberen Gehäuseteils geführtes Verbindungskabel auf einer Platine in dem Gehäuse mittels eines Steckverbinders angeschlossen ist.

Zu einem stabilen Aufbau und einer guten Ablesbarkeit tragen die Maßnahmen bei, dass die Sichtscheibe aus entspiegeltem Plexiglas ausgebildet ist und an einem Umfangsrand eines ein Sichtfeld freigebenden Ausschnitts der Trägermatte eingeklebt ist.

Der Aufbau und die Montage werden des Weiteren dadurch begünstigt, dass hinter der Sichtscheibe in der Aufnahme des oberen Gehäuseteils eine Aussparung gebildet ist, in die eine rückseitig an eine Elektronik angeschlossene Anzeige eingesetzt ist.

Die Dichtigkeit und die Handhabung werden dadurch begünstigt, dass die Aufnahme von einem in eine Grundebene übergehenden umlaufenden Absatz umgeben ist, dessen umlaufende Kontur an die Kontur der Trägermatte für ein spaltloses Einsetzen angepasst ist und dessen Höhe auf die Dicke der Trägermatte in dem jeweiligen Randabschnitt abgestimmt ist.

Vorteile für die Bedienung ergeben sich des Weiteren dadurch, dass die Sichtscheibe zumindest bezüglich der Längserstreckung des Gehäuses zentral in der Mitte der Trägermatte angeordnet ist und die Tastenanordnung zwei symmetrisch auf beiden Seiten der Sichtscheibe angeordnete Teil-Tastenfelder aufweist.

Zu einem dichten, robusten Aufbau tragen auch die Maßnahmen bei, dass die Trägermatte flächig in die Aufnahme eingeklebt ist. Die Montage wird dabei dadurch begünstigt, dass die Trägermatte auf ihrer Rückseite mit einem doppelseitigen Klebeband versehen ist.

### Kurze Beschreibung der Zeichnungen

Die Erfindung wird nachfolgend anhand von Ausführungsbeispielen unter Bezugnahme auf die Zeichnungen näher erläutert. Es zeigen:
Fig. 1A, 1B und 1C ein oberes Gehäuseteil eines Handtestgerätes in perspektivischer Ansicht schräg von oben, schräg von unten und von vom oben,
Fig. 2 ein Gehäuseunterteil mit Platine und eine von dem oberen Gehäuseteil losgelöste Bedieneinheit in perspektivischer Ansicht von schräg oben und
Fig. 3 den oberen Gehäuseteil in Draufsicht, Vorderansicht und Seitenansicht.

### Ausführungsformen der Erfindung

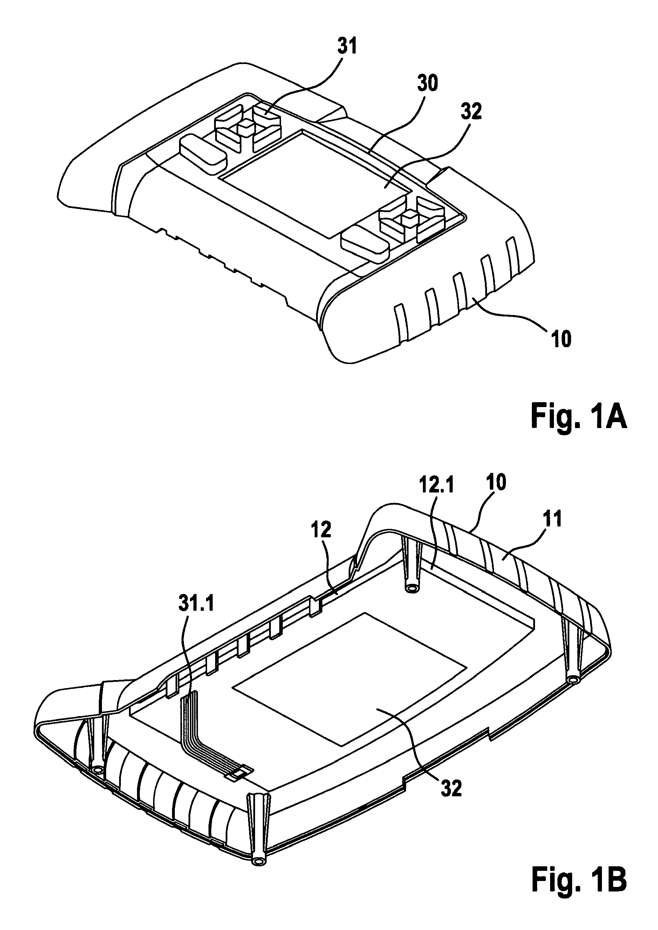

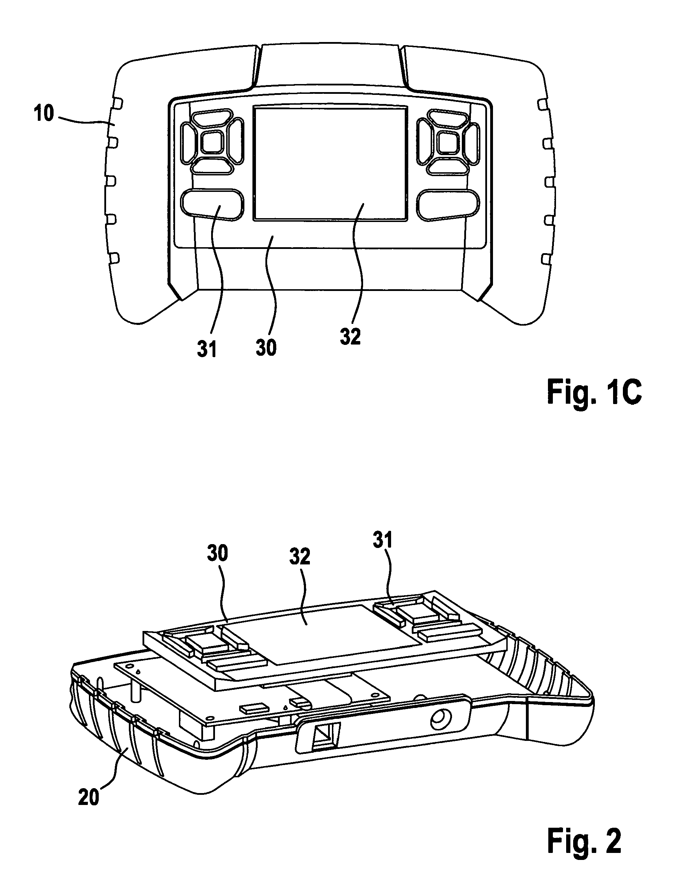

Fig. 1A, 1B und 1C zeigen in verschiedenen Ansichten ein oberes Gehäuseteil 10 eines in der Hand gehaltenen Gehäuses eines Handtestgerätes, wie es beispielsweise für die Motordiagnose verwendet wird. In Fig. 2 ist der untere Gehäuseteil 20 dargestellt. Beide Gehäuseteile 10, 20 bilden flache Halbschalen aus stabilem Kunststoffmaterial in zweikomponentiger Ausführung mit einem harten, innen angeordneten Trägermaterial und zumindest bereichsweise außen aufgebrachtem, griffigem, widerstandsfähigem, weicherem Kunststoffmaterial. Die Form ist auf ein einfaches Halten in einer Hand und Betätigen bzw. Ablesen einer Bedieneinheit 30 abgestimmt, die in dem zentralen flachen Bereich des oberen Gehäuseteils 10 angeordnet ist. Zur Griffigkeit und sicheren Handhabung tragen wulstige Randbereiche sowohl an dem unteren Gehäuseteil 20 als auch dem oberen Gehäuseteil 10 bei, die den Umfangsbereich 11 des Gehäuses bestimmen.

Die Bedieneinheit 30 weist eine Tastenanordnung 31 mit zwei Teil-Tastenfeldern auf, die seitlich symmetrisch neben einem zentral angeordneten Anzeigefeld angeordnet sind, welches von einer Sichtscheibe 32 dicht abgedeckt ist. Von der Tastenanordnung führt ein Verbindungskabel 31.1 durch eine Öffnung in der Deckwand des oberen Gehäuseteils 10 und wird auf einer im unteren Gehäuseteil 20 montierten, elektronische Bauelemente tragenden Platine eingesteckt.

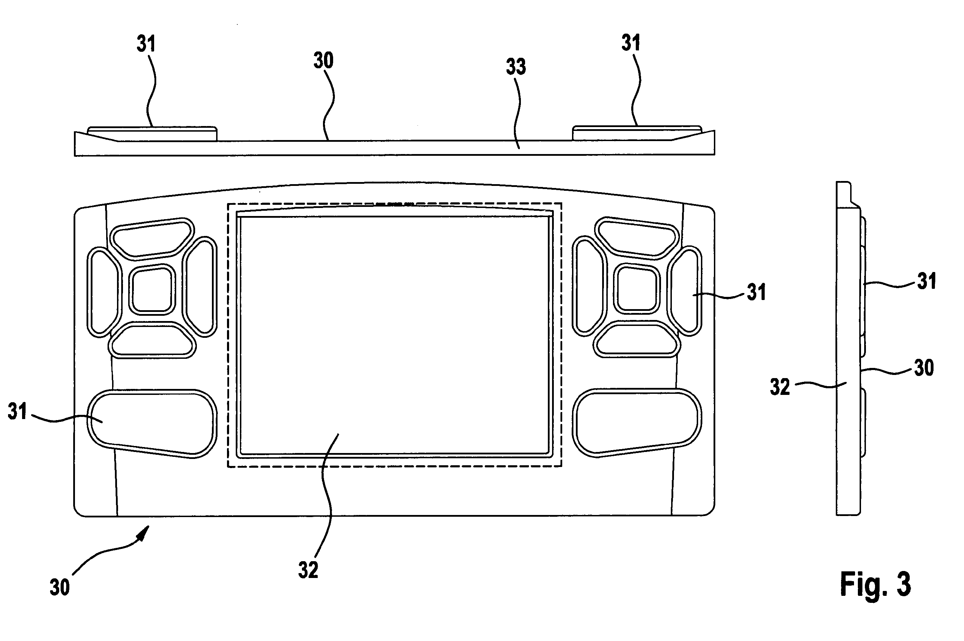

Die auch in Fig. 3 in Draufsicht, von vom und in einer Seitenansicht gezeigte Bedieneinheit 30 besitzt als Trägereinheit eine Trägermatte 33, die zumindest teilweise aus flexiblem, elastischem Material hergestellt ist und in der Verbindungsleitungen eingebettet sind, die mit den Tasten der Tastenanordnung 31 verbunden sind. Die Tasten besitzen in die einstückige Trägermatte 33 dicht integrierte und einstückig eingebundene Silikonflanken und als Schaltelemente Schnappscheiben, wodurch sozusagen eine Silikonschaltmatte mit den Schnappscheiben als Betätigungselemente gebildet wird. Die Silikontasten ergeben eine sichere Betätigung, Funktion und Abdichtung gegen Staub und Feuchtigkeit.

In der Trägermatte 33 ist bezüglich der Längserstreckung zentral ein Sichtfenster ausgeschnitten, das von der Sichtscheibe 32 abgedeckt ist, die mit ihrem Rand umlaufend um den Randbereich des Fensters an der Trägermatte dicht angeklebt bzw. eingeklebt ist und aus entspiegeltem Plexiglas besteht. Hinter der Sichtscheibe ist eine Anzeigeeinheit in einem zentralen Durchbruch der Deckwand des oberen Gehäuseteils 10 eingesetzt und über ein Verbindungskabel mit der Elektronik verbunden.

Auf der Außenseite des oberen Gehäuseteils 10 ist, umgeben von den wulstartigen Umfangsbereichen 11 eine vertiefte Aufnahme 12 gebildet, deren Grundebene von der oberen Deckwand des oberen Gehäuseteils 10 gebildet wird und die über einen umlaufenden Absatz 12.1 in der oberen Gehäuseseite eingelassen ist. Der Absatz 12.1 ist in seiner Höhe an die Höhe des entsprechenden Umfangsbereichs der Trägermatte 33 und in Umfangsrichtung an die Kontur der Trägermatte 33 angepasst, so dass sich ein flächenbündiger Übergang zwischen der Oberseite des oberen Gehäuseteils 10 und der Oberseite der Trägermatte 33 ohne Spalt ergibt, wodurch eine hohe Dichtigkeit erhalten wird. Auf der Unterseite der Trägermatte 33 ist eine Klebeschicht vorzugsweise mittels eines doppelseitigen Klebebandes aufgebracht, so dass die Trägermatte 33 flächig auf die flache Grundebene der Aufnahme 12 aufgeklebt ist. Vor der Montage ist die äußere Klebeschicht der Trägermatte 33 mittels einer Abdeckfolie abgedeckt, die vor dem Aufkleben abgezogen wird.

Der Aufbau der oberen Gehäuseschale mit der Aufnahme und der einstückigen Trägermatte 33 mit der Tastenanordnung 31 und der Sichtscheibe 32 ergeben eine einfache, dichte Montage mit einem genauen, stabilen Sitz.

## Patentansprüche

1. Handtestgerät mit einem bei der Benutzung in der Hand gehaltenen Gehäuse aus einem flachen unteren Gehäuseteil (20) und einem flachen oberen Gehäuseteil (10), in dessen Oberseite eine Bedieneinheit (30) mit Tastenanordnung (31) und Sichtanzeigefeld aufgenommen ist,
**dadurch gekennzeichnet,**
**dass** die Bedieneinheit (30) eine einstückige, von dem oberen Gehäuseteil (10) getrennt hergestellte Trägereinheit (33) aufweist, die in einer vertieften Aufnahme (12) des oberen Gehäuseteils (10) eingesetzt und festgelegt ist und in der sowohl die Tastenanordnung (31) als auch eine Sichtscheibe (32) unter Abdichtung integriert sind.

2. Handtestgerät nach Anspruch 1,
**dadurch gekennzeichnet,**
**dass** die Trägereinheit als Trägermatte (33) aus flexiblem und/oder elastischem Material hergestellt ist.

3. Handtestgerät nach Anspruch 1 oder 2,
**dadurch gekennzeichnet,**
**dass** die Tastenanordnung (31) als mindestens eine Silikonschaltmatte mit Silikonflanken aufweisenden Tasten und Schnappscheiben aufweisenden Betätigungselementen ausgebildet ist.

4. Handtestgerät nach Anspruch 2 oder 3,
**dadurch gekennzeichnet,**
**dass** die Tastenanordnung (31) an in die Trägermatte (33) eingebetteten elektrischen Verbindungsleitungen angeschlossen ist und über ein aus der Trägermatte (33) herausgeführtes, durch eine Durchgangsöffnung in der Wandung des oberen Gehäuseteils (10) geführtes Verbindungskabel (31.1) auf einer Platine in dem Gehäuse mittels eines Steckverbinders angeschlossen ist.

5. Handtestgerät nach einem der Ansprüche 2 bis 4,
**dadurch gekennzeichnet,**
**dass** die Sichtscheibe (32) aus entspiegeltem Plexiglas ausgebildet ist und an einem Umfangsrand eines ein Sichtfeld freigebenden Ausschnitts der Trägermatte (33) eingeklebt ist.

6. Handtestgerät nach einem der vorhergehenden Ansprüche,
**dadurch gekennzeichnet,**
**dass** hinter der Sichtscheibe (32) in der Aufnahme (12) des oberen Gehäuseteils (10) eine Aussparung gebildet ist, in die eine rückseitig an eine Elektronik angeschlossene Anzeige eingesetzt ist.

7. Handtestgerät nach einem der Ansprüche 2 bis 6,
**dadurch gekennzeichnet,**
**dass** die Aufnahme (12) von einem in eine Grundebene übergehenden umlaufenden Absatz umgeben ist, dessen umlaufende Kontur an die Kontur der Trägermatte (33) für ein spaltloses Einsetzen angepasst ist und dessen Höhe auf die Dicke der Trägermatte (33) in dem jeweiligen Randabschnitt abgestimmt ist.

8. Handtestgerät nach einem der Ansprüche 2 bis 7,
**dadurch gekennzeichnet,**
**dass** die Sichtscheibe (32) zumindest bezüglich der Längserstreckung des Gehäuses zentral in der Mitte der Trägermatte (33) angeordnet ist und die Tastenanordnung zwei symmetrisch auf beiden Seiten der Sichtscheibe (32) angeordnete Teil-Tastenfelder auf weist.

9. Handtestgerät nach einem der Ansprüche 2 bis 8,
**dadurch gekennzeichnet,**
**dass** die Trägennatte (33) flächig in die Aufnahme (12) eingeklebt ist.

10. Handtestgerät nach Anspruch 9,
**dadurch gekennzeichnet,**
**dass** die Trägermatte (33) auf ihrer Rückseite mit einem doppelseitigen Klebeband versehen ist.

## Claims

1. Handheld testing device having a housing which is held by hand when in use and comprises a flat lower housing part (20) and a flat upper housing part (10), an operator control unit (30) having a keypad arrangement (31) and a visual display panel being accommodated in the upper face of said flat upper housing part,
**characterized**
**in that** the operator control unit (30) has an integral support unit (33) which is produced separately from the upper housing part (10) and is inserted and secured in a recessed receptacle (12) in the upper housing part (10), and in which both the keypad arrangement (31) and a viewing window (32) are integrated in a sealed manner.

2. Handheld testing device according to Claim 1,
**characterized**
**in that** the support unit is produced, in the form of a support mat (33), from flexible and/or elastic material.

3. Handheld testing device according to Claim 1 or 2,
**characterized**
**in that** the keypad arrangement (31) is in the form of at least one silicone switching mat with keys having silicone flanks and operating elements having snap-action discs.

4. Handheld testing device according to Claim 2 or 3,
**characterized**
**in that** the keypad arrangement (31) is connected to electrical connecting lines which are embedded in the support mat (33) and is connected on a printed circuit in the housing by means of a plug connector via a connecting cable (31.1) which is routed out of the support mat (33) and through a passage opening in the wall of the upper housing part (10).

5. Handheld testing device according to one of Claims 2 to 4,
**characterized**
**in that** the viewing window (32) is formed from anti-reflective Plexiglas and is adhesively bonded to a peripheral edge of a cutout in the support mat (33), the said cutout creating a viewing area.

6. Handheld testing device according to one of the preceding claims,
**characterized**
**in that** an opening is formed behind the viewing window (32) in the receptacle (12) of the upper housing part (10), a display, of which the rear face is connected to an electronics system, being inserted into the said opening.

7. Handheld testing device according to one of Claims 2 to 6,
**characterized**
**in that** the receptacle (12) is surrounded by a peripheral projection which merges with a basic plane, the peripheral contour of the said projection being matched to the contour of the support mat (33) for the purpose of continuous insertion and the height of the said projection being matched to the thickness of the support mat (33) in the respective edge section.

8. Handheld testing device according to one of Claims 2 to 7,
**characterized**
**in that** the viewing window (32) is arranged in the centre of the support mat (33) at least centrally relative to the longitudinal extent of the housing, and the key arrangement has two key panel elements which are arranged symmetrically on both sides of the viewing window (32).

9. Handheld testing device according to one of Claims 2 to 8,
**characterized**
**in that** the support mat (33) is adhesively bonded in the receptacle (12) such that it is flat.

10. Handheld testing device according to Claim 9,
**characterized**
**in that** the support mat (33) is provided with a double-sided adhesive tape on its rear face.

## Revendications

1. Appareil de test manuel, comprenant un boîtier tenu dans la main lors de l'utilisation, constitué d'une partie de boîtier inférieure plate (20) et d'une partie de boîtier supérieure plate (10), dans le côté supérieur de laquelle est reçue une unité de commande (30) avec un agencement de touches (31) et un champ d'affichage visuel,
**caractérisé en ce que**
l'unité de commande (30) présente une unité de support (33) d'une seule pièce, fabriquée séparément de la partie de boîtier supérieure (10), qui est insérée et fixée dans un logement renfoncé (12) de la partie de boîtier supérieure (10) et dans laquelle sont intégrés à la fois l'agencement de touches (31) et un panneau de visualisation (32), et ce de manière hermétique.

2. Appareil de test manuel selon la revendication 1,
**caractérisé en ce que**
l'unité de support est réalisée sous forme de natte de support (33) en matériau flexible et/ou élastique.

3. Appareil de test manuel selon la revendication 1 ou 2,
**caractérisé en ce que**
l'agencement de touches (31) est réalisé sous forme d'au moins une natte de commutation en silicone avec des touches présentant des bords en silicone et des éléments de commande présentant des disques à cliquets.

4. Appareil de test manuel selon la revendication 2 ou 3,
**caractérisé en ce que**
l'agencement de touches (31) est raccordé à des conduites de connexion électriques noyées dans la natte de support (33), et est raccordé, au moyen d'un connecteur à fiche, par le biais d'un câble de connexion (31.1) guidé hors de la natte de support (33), guidé à travers une ouverture de passage dans la paroi de la partie de boîtier supérieure (10), sur une platine dans le boîtier.

5. Appareil de test manuel selon l'une quelconque des revendications 2 à 4,
**caractérisé en ce que**
le panneau de visualisation (32) est réalisé en plexiglas dépoli, et est collé sur un bord périphérique d'une portion de la natte de support (33) libérant un champ de vision.

6. Appareil de test manuel selon l'une quelconque des revendications précédentes,
**caractérisé en ce que** derrière le panneau de visualisation (32) dans le logement (12) de la partie supérieure du boîtier (10) est formé un évidement dans lequel est inséré un affichage raccordé par l'arrière à une électronique.

7. Appareil de test manuel selon l'une quelconque des revendications 2 à 6,
**caractérisé en ce que**
le logement (12) est entouré par un épaulement périphérique se prolongeant dans un plan de base, dont le contour périphérique est adapté au contour de la natte de support (33) en vue d'une insertion sans interstice, et dont la hauteur est adaptée à l'épaisseur de la natte de support (33) dans la portion de bord respective.

8. Appareil de test manuel selon l'une quelconque des revendications 2 à 7,
**caractérisé en ce que**
le panneau de visualisation (32) est disposé au moins par rapport à l'étendue longitudinale du boîtier centralement au milieu de la natte de support (33) et l'agencement de touches présente deux champs de touches partiels disposés symétriquement des deux côtés du panneau de visualisation (32).

9. Appareil de test manuel selon l'une quelconque des revendications 2 à 8,
**caractérisé en ce que**
la natte de support (33) est collée à plat dans le logement (12).

10. Appareil de test manuel selon la revendication 9,
**caractérisé en ce que**
la natte de support (33) est pourvue sur son côté arrière d'une bande adhésive double face.
